# EUROPÄISCHE PATENTANMELDUNG

(11) **EP 0 820 149 A2**
(43) Veröffentlichungstag der Anmeldung: **21.01.1998**
(21) Anmeldenummer: 97112179.3
(22) Anmeldetag: 16.07.1997
(51) Int. Cl.: H03M 7/30

(54) **Verfahren zur zeitoptimierten Datenübertragung zwischen mindestens einem Sender und mindestens einem Empfänger**

(30) Priorität: 16.07.1996 DE 19628684; 25.07.1996 DE 19630127
(71) Anmelder: Connect Plus Ingenieurgesellschaft für Datentechnik mbH, 99085 Erfurt (DE)
(72) Erfinder: Gründler, Frithjof, Dipl.-Ing., 99085 Erfurt (DE); Mielack, Peter, Dipl.-Ing., 99097 Erfurt (DE)
(74) Vertreter: Kruspig, Volkmar, Dipl.-Ing.

(57) **Zusammenfassung**

Die Erfindung betrifft ein Verfahren zur zeitoptimierten Datenübertragung zwischen mindestens einem Sender und mindestens einem Empfänger, wobei sowohl auf der Sender- und Empfängerseite identische Berechnungsmodelle vorgesehen sind. Diese Modelle liefern bei gleichen Eingangsdaten identische Ausgangsdaten und entsprechen in ihrem Verhalten jeweils den senderseitigen datenerzeugenden Systemen. Das eigentliche Berechnen erfolgt zeitsynchron gesteuert jeweils gleichzeitig auf der Sender- und Empfängerseite. Senderseitig wird ein Vergleich des aktuell berechneten Wertes mit den Werten des datenerzeugenden Systems, z.B. eines Meßsensors vorgenommen. Bei festgestellter, außerhalb einer vorgebbaren Toleranz liegender Abweichung zwischen senderseitigem Meßwert und Berechnungswert wird ein neuer aktualisierter Modellparameter festgelegt und nur dieser Modellparameter zur Empfängerseite übertragen. Im Anschluß erfolgt eine Neuberechnung des empfängerseitigen Wertes unter Nutzung des empfangenen aktualisierten Modellparameters. Hierdurch kann die eigentliche Übertragungszeit und Übertragungsmenge auf das zur Aktualisierung des bzw. der Parameter notwendige Maß beschränkt werden.

## Beschreibung

Die Erfindung betrifft ein Verfahren zur zeitoptimierten Datenübertragung zwischen mindestens einem Sender und mindestens einem Empfänger.

Beispielsweise aus der EP 0 448 802 A2 oder der EP 0 154 860 A2 sind Verfahren unter Nutzung der Datenkompression und Datendekompression zur Übertragung relativ großer Datenmengen oder von kleineren Datenmengen in kürzerer Zeit bekannt.

Diese bekannten Verfahren benutzen eine modellgesteuerte Datenkompression bzw. Datendekompression, um, gegebenenfalls adaptiv, größere Datenmengen entsprechend dem jeweiligen Aufkommen über eine vorgegebene Verbindungsstrecke zu übertragen.

Dabei wird in Abhängigkeit von dem Datenstrom jeweils ein Modell zum eigentlichen Komprimieren bzw. Dekomprimieren der Daten ausgewählt. Die Notwendigkeit des Vorsehens einer großen Varianz von Modellen ergibt sich bereits dadurch, daß jeder Kompressions- oder Dekompressionsschritt entsprechend des jeweiligen Verdichtungsgrades erheblichen Aufwand damit Rechenzeit nach sich zieht. Insbesondere bei sich qualitativ oder umfangsmäßig ändernden Datenströmen kann die Übertragungszeit bzw. das Übertragungsvolumen der Daten durch Modellauswahl dynamisch gestaltet und dadurch optimiert werden.

Darüber hinaus ist es bekannt, eine Übertragung von Daten von einem Sender zu einem Empfänger nur dann vorzunehmen, wenn sich senderseitig ermittelte Meßwerte um einen vorbestimmten Betrag ändern. Hierdurch kann der Zugriff auf die Datenübertragungsstrecke minimiert werden. Bei sich ständig auch nur gering ändernden Meßwerten, z.B. dem Füllstand von Hochbehältern, Betriebszuständen von Maschinen und Anlagen, Windgeschwindigkeit und dergleichen kann mit einer derartigen Methode durch Vorgabe eines großen Toleranzbereiches zwar eine Zeiteinsparung erreicht werden, jedoch sind die empfängerseitig vorhandenen Werte ungenau und für eine weitere Verarbeitung nur bedingt geeignet.

Hinsichtlich des Bekannten verbleibt zusammenfassend festzustellen, daß sogenannte modellbasierende Verfahren einerseits auf feste Modelle zurückgreifen, die für eine ganz bestimmte Sorte von Datenströmen, z.B. Telefaxdaten, digitalisierte Sprachdaten oder Bilddaten, optimiert sind. Darüber hinaus existieren adaptive Modelle, wobei sich die Modelleigenschaften den jeweiligen Gegebenheiten des Datenstromes, z.B. durch Parametervariation oder Modellwechsel, anpassen. Bei symmetrischen Modellen wird eines der Modelle auf der Senderseite zur Kodierung und ein entsprechendes Modell als Gegenstück auf der Empfängerseite zur Dekodierung bzw. Dekompression benutzt. Letztendlich ist es bekannt, die Auswahl eines Modells oder der Modellparameter anhand der Eigenschaften des Datenstromes, z.B. der Häufigkeitsverteilung bestimmter Symbole vorzunehmen. Allen bekannten modellbasierenden Verfahren ist es jedoch gemeinsam, daß das auf der Empfängerseite vorhandene Modell seine Ausgangsdaten einzig und allein anhand der über die Übertragungsstrecke eintreffenden kodierten Daten generiert. Das heißt, es wird dann, und nur dann, wenn kodierte Daten bei der Dekodier- oder Dekompressionseinheit eintreffen, eine der Dekodiervorschrift entsprechende feste Anzahl von Ausgangsdaten erzeugt.

Diese kurz beschriebenen bekannten Datenübertragungsverfahren sind für bestimmte Anwendungsfälle optimierbar, wobei beispielsweise die Kompression bei der Übertragung einer relativ großen Datenmenge in einer möglichst kurzen Zeit der eigentlichen Reduzierung des Datenvolumens dient, wie das z.B. bei Telefaxdatenübertragung der Fall ist. Andererseits kann durch Kompressionsverfahren das Problem gelöst werden, einen kontinuierlichen Datenstrom mit hoher Datenrate Über einen einzigen Übertragungskanal mit relativ geringer Bandbreite zu übertragen.

In sogenannten Fernwirksystemen können mit den bekannten Datenkompressionsverfahren Übertragungen der in Datenaufnahmestationen in Außenstellen gespeicherten Daten, z.B. Tages-, Wochen- oder Monatsblöcke von Meßwerten, vorgenommen werden, wobei die eigentliche Übertragung der gespeicherten, jedoch komprimierten Datenmenge in einer kurzen Zeiteinheit denkbar ist.

Probleme bestehen dann, wenn zeitoptimiert online ein Datentransfer notwendig ist. Zum Beispiel bei der Flußpegelüberwachung ist es erforderlich, online den jeweiligen Pegelstand zu übertragen, wobei hier nicht das Problem der großen Datenmenge relevant ist, sondern der Zugriff auf z.B. ein öffentliches Netz zur Datenübertragung den eigentlichen Kostenfaktor darstellt. Bei bekannten Fernwirkstationen fallen beispielsweise in einer Zeit von ca. 15 Minuten 20 bis 30 Meßwerte an, die zu übertragen sind. Eine bekannte, herkömmliche Datenkompression dieser relativ geringen Meßwertanzahl führt nicht zu einer Gebühreneinsparung, wenn von dem üblichen Zeittakt eines öffentlichen Telefonnetzes ausgegangen wird.

Ein ähnliches Problem ergibt sich dann, wenn beispielsweise die Datenübertragung mittels Funkübertragungssystemen, z.B. Bündel- oder Chekkerfunk durchzuführen ist. Hier ist zwar derzeit die eigentliche Datenübertragung, d.h. das zeitliche Belegen der jeweiligen Kanäle noch kostenlos, jedoch ist die Kanalanzahl begrenzt, so daß bei einer großen Anzahl von Fernwirkstationen es nicht immer in ausreichendem Maße möglich ist, über die jeweilige Zeitdauer einen freien Übertragungskanal zur Verfügung zu haben. Hier würde ein zeitoptimierter Zugriff auf das jeweilige Funkübertragungsnetz zu wesentlich größerem Freiheitsgrad bei der Erhöhung der Anzahl der Fernwirkstationen je Netz bzw. der Aktualität der Daten, die empfängerseitig vorhanden sind, führen.

Es ist daher Aufgabe der Erfindung, ein Verfahren zur zeitoptimierten Datenübertragung zwischen mindestens einem Sender und mindestens einem Empfänger anzugeben, das es gestattet, empfängerseitig möglichst ständig aktuelle, systembeschreibende Daten, quasi Online zur Verfügung zu haben und andererseits den Zugriff zu öffentlichen Netzen oder Funkdatenübertragungssystemen für die notwendige Aktualisierung der Empfängerdaten zeitlich zu optimieren, so daß sich die Kosten beim Betreiben von z.B. Fernwirksystemen mit Datenübertragung reduzieren.

Die Lösung der Aufgabe der Erfindung erfolgt mit einem Verfahren gemäß den Merkmalen des Patentanspruchs 1, wobei die Unteransprüche mindestens zweckmäßige Ausgestaltungen und Weiterbildungen des erfindungsgemäßen Verfahrens umfassen.

Ein wesentlicher Grundgedanke der Erfindung besteht darin, bei dem Verfahren zur zeitoptimierten Datenübertragung zwischen mindestens einem Sender und mindestens einem Empfänger von identischen Berechnungsmodellen auf der Sender- und Empfängerseite auszugehen, wobei die Modelle bei gleichen Eingangsdaten identische Ausgangsdaten liefern und die jeweiligen Modelle entsprechend dem Verhalten des senderseitigen datenerzeugenden Systems ausgewählt sind.

Das Berechnen sowohl sender- als auch empfängerseitig erfolgt zeitsynchron gesteuert, d.h. es werden jeweils neue aktualisierte Daten bzw. Werte gleichzeitig auf der Sender- und Empfängerseite erzeugt. Senderseitig wird in vorgegebenen Zeitabständen bzw. kontinuierlich ein Vergleichen des aktuell berechneten Wertes mit den Meßwerten des datenerzeugenden Systems, z.B. eines Meßsensors, vorgenommen, wobei bei festgestellter, außerhalb einer vorgegebenen Toleranz liegender Abweichung von senderseitigen Meßwerten zum Berechnungswert ein neuer aktualisierter Modellparameter festgelegt wird.

Es erfolgt dann wenigstens bzw. nur ein Übertragen dieses geänderten aktualisierten Modellparameters hin zur Empfängerseite mit anschließender Neuberechnung des empfängerseitigen Wertes unter Nutzung dieses empfangenen, aktualisierten neuen Modellparameters.
Hierdurch ergibt sich eine wesentliche Reduzierung der Zugriffszeit auf ein öffentliches Datenübertragungsnetz, z.B. ein Telefonnetz oder ein Funkübertragungssystem.

Dadurch, daß erfindungsgemäß beide Modelle hinreichend identisch sind, liefern diese bei gleichen Eingangsdaten gleiche Ausgangsdaten. Die Berechnung des neuen Wertes erfolgt erfindungsgemäß gleichzeitig auf der Sender- und Empfängerseite, gesteuert von beispielsweise synchron laufenden Zeitgebern, wobei auf sogenannte DCF-Module zurückgegriffen werden kann. In dem Falle, wenn der neue, berechnete Wert nicht mit dem vom jeweiligen Meßsensor gelieferten Wert übereinstimmt bzw. dann, wenn eine Abweichung eine vorgegebene Toleranzschwelle überschreitet, wird der Modellparameter neu berechnet und nur dieser zur Senderseite übertragen. Danach kann dann auf Sender- und Empfängerseite die Berechnung des neuen, geltenden Wertes wiederholt werden.

Gemäß einem weiteren Grundgedanken der Erfindung wird dann, wenn mehrere Meßsensoren bzw. mehrere Datenmengen oder Datenströme vorhanden sind, jedem datenerzeugenden System bzw. jedem Datenstrom ein entsprechendes Modell zugeordnet. Hierbei werden dann jedem Modell eines datenerzeugenden Systems die Werte und die Parameter der übrigen datenerzeugenden Systeme als Eingangsdaten zur Verfügung gestellt.
Mit einer derartigen Anordnung läßt sich z.B. das Verhalten einer Pumpstation mit Hochbehälter respektive Zu- und Abfluß im Bereich Trinkwasserversorgung exakt nachbilden, da bei einem solchen Problem alle zu übertragenden Meßwerte vom zeitlichen Verlauf der entnommenen Wassermenge abhängen. Konkret ist in diesem Fall die Pumpe dann aktiviert, wenn eine bestimmte Menge aus dem Behälter entnommen wurde, und es ergibt sich eine mit dieser Menge korrelierte Wasserzuflußmenge.

Gemäß einem weiteren Grundgedanken der Erfindung wird bei dem Verfahren die Auswahl und Bestimmung der Modelle derart vorgenommen, daß diese sich adaptiv zum jeweiligen physikalischen Sachverhalt verhalten, der dem senderseitigen datenerzeugenden System entspricht.

In einer Ausführungsform des erfindungsgemäßen Verfahrens wird im Falle des Nichtübereinstimmens von senderseitigen Meßwerten und Modellberechnungwerten, d.h. von gemessenem Ist- und berechnetem Istwert sowohl der aktualisierte Modellparameter als auch der jeweilige senderseitige gemessene Istwert zum Empfänger übertragen, so daß die Genauigkeit der empfängerseitig erhaltenen Datenmenge bzw. des Datenstromes erhöht ist.

Weiterhin erfindungswesentlich wird bei dem vorgestellten Verfahren bei zu erwartenden Übertragungszeiten zwischen Sender und Empfänger, die im Verhältnis zum Takt des zeitsynchron gesteuerten Berechnens groß sind, eine Zwischenspeicherung der berechneten Werte vorgenommen. Diese zwischengespeicherten berechneten Werte werden erst dann freigegeben, wenn nach vorgegebner Zeit eine senderseitige Bestätigung eingeht oder die vorgegebene Zeit ohne Übertragung eines neuen Parameters verstrichen ist, wodurch quasi die Gültigkeit der gespeicherten Werte indirekt bestätigt wurde.

Bei dieser Ausführungsform wird insbesondere bei langer Übertragungszeit der Zeitpunkt der Parameterneuberechnung ebenfalls übermittelt, um die Menge ggfs. zu verwerfender modellberechneter Daten zu bestimmen. Die Wertepaare [Zeitpunkt der Parameterberechnung, Parameter] können dabei auf einem Datenträger gespeichert werden und zu einem späteren Zeitpunkt der Empfängereinheit zugeführt werden. Dies entspricht einer sehr langen Übertragungszeit.

Ein weiterer wesentlicher Grundgedanke der Erfindung besteht darin, daß bei einem empfängerseitig zeitsynchronen, jedoch schneller getakteten Betrieb und damit Vorausberechnung der Modellwerte aus den aktuell berechneten Werten ein voraussichtlich zu erwartender Verlauf der Datenmenge abschätzbar ist, wodurch sich dann Vorteile ergeben, wenn z.B. in Energie- oder Wasserversorgungsanlagen Leistungs- bzw. Verbrauchsspitzen erkannt werden sollen und geeignete Maßnahmen zur Überlastsicherung getroffen werden sollen.

Zusätzlich kann bei vorhandener Differenz zwischen modellberechneten Istwerten und gemessenen Werten das jeweilige senderseitige Modell so ausgebildet sein, daß dieses sich selbst korrigiert, wobei dann dieser Korrekturparameter zur Empfängerseite übertragen wird.

Erfindungsgemäß wird das Verfahren zur zeitoptimierten Online-Datenübertragung in Fernwirksystemen verwendet, welche Daten zur zeitnahen Information einer zentralen Überwachungsstelle zur Verfügung stellen sollen. Dies ist beispielsweise in dem Bereich der Flußpegelüberwachung, Trinkwasserversorgung, Abwasserentsorgung, Gas- und Fernwärmeversorgung der Fall.

Das vorstehend beschriebene Verfahren läßt sich sowohl hardwareseitig als auch softwareseitig realisieren bzw. umsetzen. Als erfassungs- bzw. zentral- oder empfängerseitiger Rechner kann ein Transputersystem Verwendung finden. Die Verfahrensschritte können softwareseitig als parallel laufende Prozesse installiert werden.

Im Gegensatz zu bekannten Verfahren, erfolgt keine Datenkompression z.B. durch arithmetische Kodierung an sich, sondern es wird eine Nachbildung des zeitlichen Verlaufes der einzelnen Datenmenge bzw. Datenströme erreicht. Die Modelle sind nicht wie beim Bekannten adaptiv zu den Eigenschaften des eingehenden Datenstromes, sondern verhalten sich analog der jeweiligen physikalischen Sachverhalte, d.h. analog zu den datenerzeugenden Systemen.

Dadurch, daß die Ausgangsdaten, die vom Zentralrechner weiterverarbeitet oder zur Anzeige gebracht werden, auf der bzw. den Empfängerseiten zeitgesteuert generiert werden unter Nutzung der jeweiligen Modelle, ist eine Verbindung zwischen Sender und Empfänger nur bei Änderung der Modellparameter notwendig. Das heißt, es werden nur dann, wenn berechneter und gemessener Wert nicht übereinstimmen, neue Parameter und ggfs. die tatsächlich gemessenen Werte übertragen. Wie bereits kurz erwähnt, können die synchron laufenden Zeitgeber zur Taktung der Modelle hardwareseitig realisiert, aber auch als Softwaremodule bereitgestellt werden. Das erfindungsgemäße Verfahren ermöglicht demnach eine wesentliche Reduzierung der Zugriffszeit auf ein Datenübertragungsnetz, wodurch sich eine Optimierung der Datenübertragung selbst ergibt, ohne daß sich die empfangsseitigen Werte wesentlich von den jeweilig ermittelten bzw. gemessenen senderseitigen Werten unterscheiden.

Die Erfindung soll nachstehend anhand eines Ausführungsbeispiels sowie unter Zuhilfenahme von Figuren näher erläutert werden.

Hierbei zeigen:
- Fig. 1: ein Blockschaltbild zur Erläuterung des sowohl hard- als auch softwareseitig realisierbaren Verfahrens;
- Fig. 2: ein senderseitiger Aufbau mit mehreren einlaufenden Datenströmen und
- Fig. 3: ein prinzipieller empfängerseitiger Aufbau, welcher in der Lage ist, mit analogen Modellen die senderseitigen Datenströme nachzubilden und empfangene geänderte Parametersätze modellseitig zu verarbeiten.

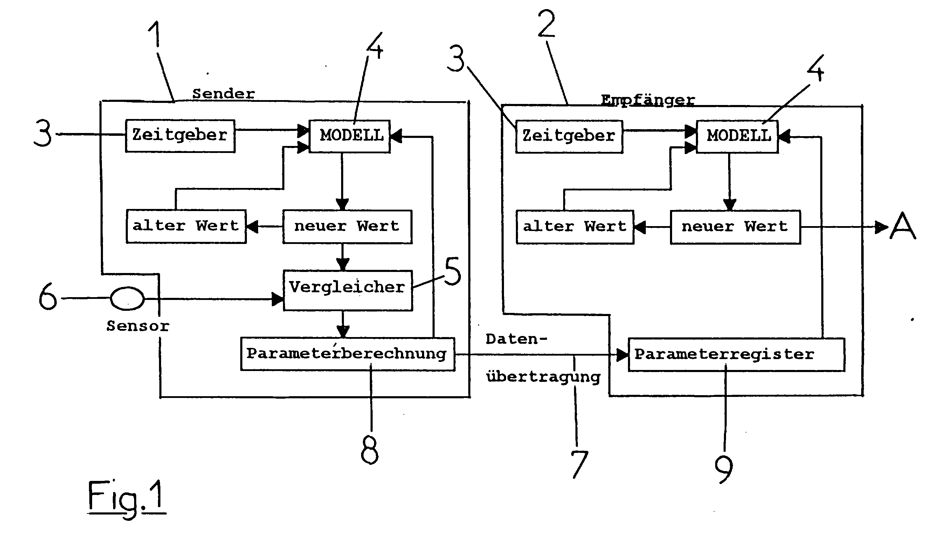

Bei dem in der Fig. 1 gezeigten Blockschaltbild ist eine Senderbaugruppe 1 sowie eine Empfängerbaugruppe 2 vorhanden. Sowohl Sender- als Empfängerbaugruppe 1; 2 weisen einen Zeitgeber 3 auf, welcher beispielsweise durch einen DCF-Empfänger bzw. ein Funkuhrmodul synchron betrieben werden kann.

Das empfänger- und senderseitige Berechnungsmodell 4 ist identisch und so konfiguriert, daß bei gleichen Eingangsdaten identische Ausgangsdaten geliefert werden. Ein einfaches Modell kann z.B. einen neuen Wert aus der Beziehung alter Wert zuzüglich Parameter X gebildet sein.

Senderseitig berechnet das Modell 4 in einem bestimmten vom Zeitgeber 3 vorgegebenen Takt laufend berechnete Istwerte, die einem Vergleicher 5 zugeführt werden. Dieser Vergleicher vergleicht die berechneten Istwerte mit jeweils von einem Sensor 6 gelieferten gemessenen Istwerten.

Im Falle des Überschreitens einer vorgegebenen Toleranz zwischen den berechneten und den gemessenen Istwerten wird ein neuer Parameter für das Modell 4 berechnet bzw. ermittelt oder unter Rückgriff auf Tabellenwerte ausgelesen. Die Datenübertragungsstrecke 7 wird nur dann in Anspruch genommen, wenn ein neu berechneter Parameter aus einer Parameterberechnungsbaugruppe 8 vorliegt. Der über die Datenübertragungsstrecke 7 zur Empfängerbaugruppe 2 gelangte neue Parameter wird in einem Parameterregister 9 zwischengespeichert und dem Berechnungsmodell 4 der Empfängerbaugruppe 2 zugeführt.

Unter Nutzung dieses neuen Parameters erfolgt dann modellgestützt die Berechnung eines neuen Wertes, der am Ausgang A zur weiteren Verarbeitung zur Verfügung steht, beispielsweise einem Zentralrechner (nicht gezeigt) übermittelt werden kann.

Bei dem vorbeschriebenen Ausführungsbeispiel wird deutlich, daß die Datenübertragungsstrecke nur in geringem Maße in Anspruch genommen wird, nämlich nur dann, wenn sich senderseitig geänderte Parameter ergeben. In dem Falle geänderter Parameter bzw. der Übertragung dieser geänderten Parameter zur Empfängerbaugruppe kann zweckmäßigerweise gleichzeitig eine Übertragung der in diesem Zeitabschnitt tatsächlich gemessenen, d.h. vom Sensor 6 bereitgestellten Werte erfolgen.

Selbstverständlich können senderseitig mehrere Senderbaugruppen 1 mit unterschiedlichen Modellen, ausgerichtet am jeweiligen physikalischen Sachverhalt angeordnet sein, wobei die Modell- bzw. Modellberechnungswerte den Modellen netzartig gegenseitig zur Verfügung gestellt werden, so daß sich quasi eine übergeordnete Netzstruktur ergibt, die in der Lage ist, adaptiv auf geänderte Sachverhalte, die es zu erfassen und zu übertragen gilt, zu reagieren.

So kann bei einer konkret realisierten Ausführungsform einer Pumpstation eine Anordnung von Sensoren für minimalen und maximalen Füllstand, Pumpe und Ablaufventil des Wasserbehälters vorgesehen sein, wobei in diesem Falle eine Verkopplung der Modelle entsprechend dem tatsächlichen physikalischen Sachverhalt beim Zuführen und Entnehmen von Wasser in bzw. aus dem entsprechenden Wasserbehälter gegeben ist.

Analog kann beispielsweise das Übertragen von Meßdaten einer Solaranlage mit Einstrahlungssensor, Temperaturfühler, Wechselrichter und Ertragszähler vorgenommen werden.

Aus der gegenseitigen Korrelation der mittels der Modelle berechneten Werte und einer empfängerseitigen Überprüfung von Erwartungswerten gestützt auf bekannte Tages-, Wochen- oder Jahresverläufe kann festgestellt werden, ob der jeweilige zu überwachende Wasserbehälter beispielsweise ein Leck aufweist. Ein derartiger Rückschluß trifft dann zu, wenn eine Neuberechnung von Modellparametern des Untermodells Pumpe notwendig wird, ohne daß das abflußseitige Modell geänderte Wasserentnahmemengen signalisiert.

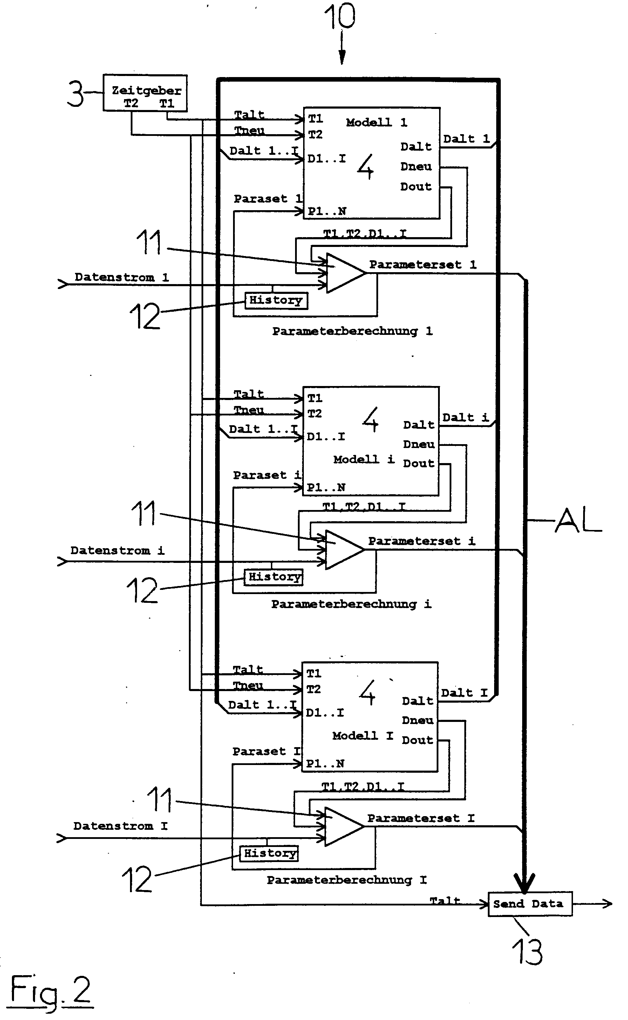

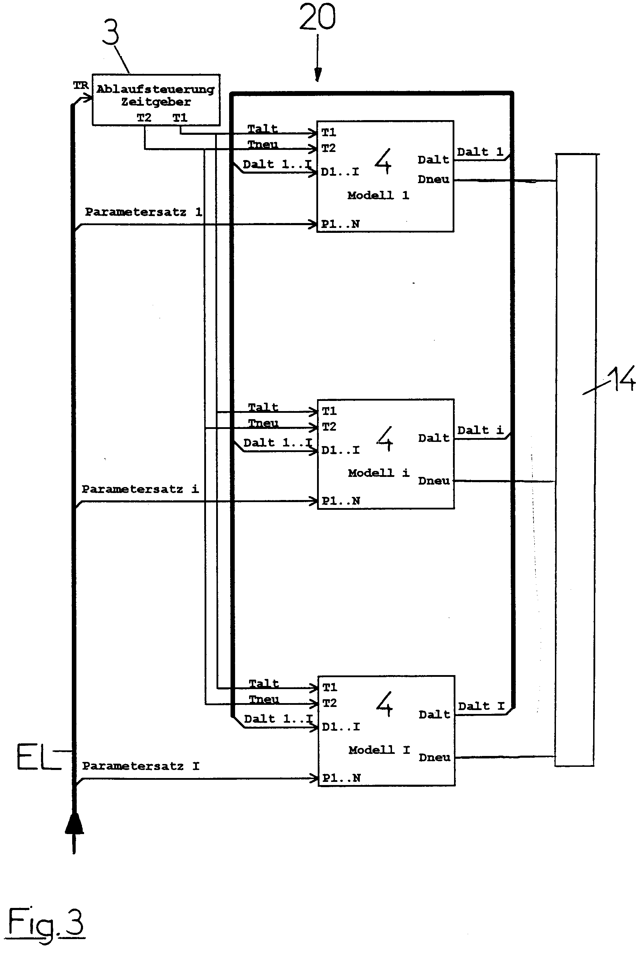

Bei den in den Fig. 2 und 3 gezeigten prinzipiellen Darstellungen von Sender- und Empfängerbaugruppen 10; 20 sind die bereits erwähnten Zeitgeber 3 vorhanden, die auch Funktionen einer Ablaufsteuerung erfüllen.

Mit den Zeiten T1 und T2 soll darauf hingewiesen werden, daß eine unterschiedliche Taktung und unterschiedliche (gleiche) Berechnungszeitpunkte für die Modelle vorgebbar sind, wodurch eine Modellkorrektur möglich ist, andererseits aber auch bei schnellerer Taktung der Empfängerbaugruppe 20 eine Vorhersage, d.h. eine Schätzung zu erwartender Werte möglich wird.

Die Senderbaugruppe 10 geht von drei einlaufenden Datenströmen 1,i,I aus, die jeweils auf eine Baugruppe zur Parametervorgabe gelangen, die auch die Funktion des Vergleiches wie anhand der Fig. 1 mit dem Bezugszeichen 5 erläutert, erfüllen.

Der jeweils einlaufende Datenstrom 1,i,I gelangt berechnungsparallel auf einen jeweils vorgesehenen Speicher 12 mit deren Hilfe eine Historiebetrachtung möglich wird und das jeweilige Modell in die Lage versetzt ist, eine selbstlernende Änderung von Parametern vorzunehmen. Die Baugruppen zur Parametervorgabe 11 gelangen dann über eine gemeinsame Ausgangsleitung AL hin zu einem Ausgabeport 13, welcher beispielsweise ein Modem oder eine sonstige Schnittstelle zur Verbindung zu einem öffentlichen Datenübertragungsnetz oder zu einem Hochfrequenz-Sender sein kann.

Die Empfängerbaugruppe 20 besitzt den bereits erwähnten Zeitgeber 30 analog und synchron betrieben zum Zeitgeber 30 der Senderbugrauppe 10.

Über einen nicht dargestellten Eingangsmodul, der ein Hochfrequenzempfänger oder ein Empfangsmodem sein kann, gelangt über eine Eingangsleitung EL der jeweils aktuelle Parametersatz 1,i,I auf die jeweiligen Modelle 1,i,I. Diese empfängerseitigen Modelle führen zeitsynchron gesteuert eine Berechnung und Ermittlung von Ausgangswerten durch, und es erfolgt eine Korrektur der Berechnungsalgorithmen durch empfangene, neue Parametersätze. Die den Modellen entnommenen jeweils aktuell berechneten Werte gelangen auf den Eingang eines übergeordneten Zentralrechners 14, welcher die weitere Auswertung und Anzeige ermöglicht.

Es ist bei einem weiteren, nicht gezeigten Ausführungsbeispiel der Erfindung möglich, die in der Empfängerbaugruppe 20 einlaufenden Daten zwischenzuspeichern, so daß quasi vorläufige Werte erhalten werden, die erst dann zum Zentralrechner hin freigegeben werden, wenn entweder senderseitig eine Bestätigung vorlag, oder wenn eine vorgegebene Zeit verstrichen ist, ohne daß ein neuer Parametersatz übertragen bzw. empfangen wurde.

Zusätzlich kann bei langer Übertragungszeit diese als Zeitwert mitübertragen und zur Wertekorrektur dergestalt verwendet werden, daß empfängerseitig dann, wenn die Information "Werte falsch" oder "Werte zu ändern" vorliegt, die bis dahin darin gespeicherten Werte, deren zeitliche Tiefe sich anhand der Übertragungszeit feststellen läßt, zu verwerfen sind. Neben dem quasi parallelen Betreiben unterschiedlicher Modelle, d.h. dem parallelen Berechnen kann auch eine geschachtelt hierarchisch geordnete Modellstruktur vorgesehen sein, wobei die Auswahl der Modelle und der Modellstruktur streng am physikalischen Verhalten des zu überwachenden Systems orientiert ist.

Alles in allem läßt sich mit den im Ausführungsbeispiel beschriebenen Verfahren, das sowohl hardware- als auch softwareseitig umsetzbar ist, insbesondere bei Fernwirk-Systemen die Anzahl der Verbindungen zwischen der oder den Außenstellen und einer zentralen Übertragungsstelle verringern, wobei dennoch zeitnah jeweils Informationen über den aktuellen Zustand der jeweiligen Außenstelle vorliegen.

### Bezugszeichenliste

- 1; 10: Senderbaugruppe
- 2; 20: Empfängerbaugruppe
- 3: Zeitgeber
- 4: Berechnungsmodell
- 5: Vergleicher
- 6: Sensor
- 7: Datenübertragungsstrecke
- 8: Parameterberechnungsbaugruppe
- 9: Parameterregister
- A: Ausgang
- 11: Parameterset
- 12: Speicher
- AL: Ausgangsleitung
- 13: Ausgangsport
- EL: Eingangsleitung
- 14: Zentralrechner

## Patentansprüche

1. Verfahren zur zeitoptimierten Datenübertragung zwischen mindestens einem Sender und mindestens einem Empfänger, umfassend folgende Schritte
- Vorsehen von identischen Berechnungsmodellen auf der Sender- und Empfängerseite, wobei die Modelle bei gleichen Eingangsdaten identische Ausgangsdaten liefern und die jeweiligen Modelle entsprechend dem Verhalten des senderseitigen datenerzeugenden Systems ausgebildet sind;
- zeitsynchron gesteuertes Berechnen jeweils neuer, aktualisierter Werte gleichzeitig auf der Sender- und Empfängerseite;
- Vergleichen des aktuell berechneten Wertes auf der Senderseite mit den Werten des datenerzeugenden Systems, z.B. eines Meßsensors;
- bei festgestellter, außerhalb einer vorgebbaren Toleranz liegender Abweichung zwischen senderseitigem Meßwert und Berechnungswert Festlegen eines neuen, aktualisierten Modellparameters und Übertragen wenigstens dieses Modellparameters zum korrespondierenden Modell der Empfängerseite sowie Neuberechnung des empfängerseitigen Wertes unter Nutzung des empfangenen aktualisierten Modellparameters.

2. Verfahren nach Anspruch 1,
dadurch gekennzeichnet,
daß bei festgestellter, außerhalb einer vorgebbaren Toleranz liegenden Abweichung zwischen senderseitigem Meßwert und Berechnungswert das Festlegen eines neuen, aktualisierten Modellparameters auf der Senderseite erfolgt und dieser Modellparameter zur Empfängerseite zur weiteren Verarbeitung übertragen wird.

3. Verfahren nach Anspruch 1,
dadurch gekennzeichnet,
daß bei festgestellter, außerhalb einer vorgebbaren Toleranz liegenden Abweichung zwischen senderseitigem Meßwert und Berechnungswert ein diese Abweichung repräsentierender Datenwert zur Empfängerseite übertragen wird, sowie das Festlegen eines neuen, aktualisierten Modellparameters auf der Empfängerseite und Übertragung dieses Modellparameters zur Senderseite zur weiteren Verarbeitung.

4. Verfahren nach Anspruch 1, 2 oder 3,
dadurch gekennzeichnet,
daß bei mehreren datenerzeugenden Systemen und Meßsensoren jeder Datenmenge eines Meßsensors mindestens ein Modell zugeordnet ist, wobei einem Modell einer Datenmenge die Datenmenge des anderen Modells im Sinne einer Vernetzung zur Verfügung gestellt wird.

5. Verfahren nach einem der vorangegangenen Ansprüche,
dadurch gekennzeichnet,
daß die Auswahl und Bestimmung der Modelle derart erfolgt, daß diese adaptiv zum jeweiligen physikalischen Sachverhalt sind, welcher dem senderseitigen datenerzeugenden System entspricht.

6. Verfahren nach einem der Ansprüche 1, 2, 4 oder 5,
dadurch gekennzeichnet,
daß im Falle des Nichtübereinstimmens von senderseitigem Meßwert und Modell-Berechnungswert sowohl der aktualisierte Modellparameter als auch der jeweilige senderseitige Meßwert zum Empfänger übertragen werden.

7. Verfahren nach einem der vorangegangenen Ansprüche,
dadurch gekennzeichnet,
daß bei zu erwartenden Übertragungszeiten zwischen Sender und Empfänger, die im Verhältnis zum Takt des zeitsynchron gesteuerten Berechnens groß sind, die berechneten Werte zwischengespeichert und erst dann freigegeben werden, wenn nach vorgegebener Zeit eine senderseitige Bestätigung eingeht oder die vorgegebene Zeit ohne Übertragung eines neuen Parameters verstrichen ist.

8. Verfahren nach Anspruch 7,
dadurch gekennzeichnet,
daß bei langer Übertragungszeit diese mitgesendet wird, um die Menge gegebenenfalls zu verwerfender modellberechneter Daten zu bestimmen.

9. Verfahren nach Anspruch 8,
dadurch gekennzeichnet,
daß die zu sendenden Wertepaare sowie die Zeit der Neuberechnung eines Modellparameters und die neuberechneten Modellparameter auf einem Datenträger gespeichert und zu einem späteren Zeitpunkt den Modellen der Empfängerseite zugeführt werden.

10. Verfahren nach einem der vorangegangenen Ansprüche,
dadurch gekennzeichnet,
daß bei empfängerseitig zeitsynchron, jedoch schneller getaktetem Betrieb und Berechnung der Modellwerte aus den aktuell berechneten Werten ein voraussichtlich zu erwartender Verlauf der Datenmenge abschätzbar ist.

11. Verfahren nach einem der Ansprüche 1 bis 9,
dadurch gekennzeichnet,
daß bei vorhandener Differenz zwischen modellberechnetem Istwert und gemessenen Istwerten sich das jeweilige Sendermodell selbst korrigiert und ein Korrekturparameter zur Empfängerseite übertragen wird.

12. Verfahren nach einem der vorangegangenen Ansprüche,
gekennzeichnet durch
seine Anwendung bei der Übertragung von Daten in Fernwirksystemen insbesondere für die Überwachung von Flußpegeln, Umwelt- und Verbrauchsdaten sowie für die Überwachung von Prozeßdatenströmen, die eine gegenseitige Abhängigkeit aufweisen.
